# EUROPEAN PATENT SPECIFICATION

(11) **EP 1 540 032 B1**
(45) Date of publication and mention of the grant of the patent: **22.11.2006**
(21) Application number: 03787880.8
(22) Date of filing: 13.08.2003
(51) Int. Cl.: C23C 14/54

(54) **THIN FILM DEPOSITION APPARATUS**
VORRICHTUNG ZUR ABSCHEIDUNG DÜNNER FILME
DISPOSITIF DE DEPOT DE COUCHES MINCES

(30) Priority: 14.08.2002 GB 0218998
(43) Date of publication of application: 15.06.2005
(73) Proprietor: Oxford Instruments Plasma Technology Limited, Witney, Oxfordshire OX8 1TL (GB)
(72) Inventor: GEORGE, Christopher, Bristol BS34 8TG (GB); WATSON, Michael, Nr Axbridge, Somerset, BS26 2PB (GB); KNIGHT, Robert, North Somerset BS22 8DY (GB); HALSALL, Brian, Upper Langford, Bristol BS40 5EA (GB); JOLLY, Timothy, Bristol BS48 4YS (GB)
(74) Representative: Skone James, Robert Edmund
(86) International application number: PCT/GB2003/003526
(87) International publication number: WO 2004/016820

(56) References cited:
- EP-A- 1 278 042
- GB-A- 1 179 413
- US-A- 3 400 687
- US-A- 3 636 917
- US-A- 4 793 908
- US-A- 5 745 240

## Description

The invention relates to thin film deposition apparatus.

Ion beam sputter deposition apparatus is an example of apparatus used to produce thin film structures on substrates. For example, thin film filters for Dense Wave Division Multiplexing (DWDM) filters and ring laser gyroscope (RLG) mirrors are made using such apparatus. These high quality filters are used in optical communications networks. Digital information is encoded onto different frequencies of light and these are multiplexed together and transmitted through optical fibres. At the receiver similar filters are used to demultiplex the light-stream into its original separate channels.

The filters are composed of many alternating layers of materials with different refractive indexes (RI). Typical layers are Silicon dioxide (SiO₂) and Tantalum pentoxide (Ta₂O₅). The different values of RI combined with the exact sequence of layers allow a device to be made that will allow the passage of some frequencies while rejecting others, thus creating a filter. In order to achieve the specification of the filter the thickness of each individual layer must be accurately maintained.

The thickness is measured with an optical monitor (OM). This directly measures the optical attenuation characteristics by shining a light, such as a laser beam, through the device and measuring the amount of transmitted light. Typically the radiation (the light) will be of infrared wavelengths but wavelengths in the visible or "white light" band are also used. DVDM filters use an infrared laser optical monitor and RLG's use a white light version. It is desirable, for reasons of accuracy, to measure the thickness during the deposition process. Therefore, the OM must be integrated into the deposition system.

The conventional layout is to mount the OM on the outside of the vacuum chamber of the apparatus with the laser shining through a vacuum sealed window and with the receiver attached to another window such that the deposited filter interrupts the beam. The advantage of this layout is that the sensitive components of the OM are not exposed to the harsh environment inside the vacuum chamber. The disadvantages are twofold; because the transmitting light source and the associated receiver are separated by a relatively large distance there are problems in maintaining the alignment. It is difficult to reduce this physical separation because of the size and geometrical constraints imposed by the other deposition components. The second problem is that because the laser and receiver are fixed to the vacuum windows this dictates the position of the filter. This imposes restrictions on the position of the other components. The result is that the flexibility of the overall system is impaired. In order to get the best quality films it is necessary to be able to adjust the angles between the major components. Mounting the OM on vacuum windows limits this adjustment.

US-A-3636917 illustrates an optical monitoring apparatus in which optical fibres extend from a source and receiver respectively through a chamber wall into the chamber itself and terminate at a fixed head adjacent the substrate.

GB1179413 also discloses a system in which optical fibres extend into the vacuum chamber adjacent a substrate.

US3400687 discloses a monitoring system in which a source and receiver are located within the chamber and this is clearly undesirable since there is a risk of damage to these sensitive components.

US-A-5745240 describes an in situ stress measurement system for measurement of stress within a thin film upon its deposition on a substrate.

More recently, thin film deposition apparatus has been developed in which not only does the substrate rotate to ensure even deposition, but the rotating substrate is itself mounted on a movable support. This latter movement makes it difficult to monitor the deposition using the techniques described above.

In accordance with the present invention, thin film deposition apparatus comprises a processing chamber within which is mounted a movable substrate support; and monitoring apparatus having a radiation generator and radiation detector and for causing radiation to impinge on a substrate on the support and to detect radiation after impingement on the substrate, and a processing system for monitoring radiation received by the radiation detector, and is characterized in that each of the radiation detector and radiation generator is coupled with respective optical fibres terminating at corresponding radiation receiving and emitting locations mounted on the substrate support and located in use on opposite sides of a substrate on the support; and in that the substrate support includes a portion which is moveable relative to the radiation emitting and receiving locations so that a substrate can be moved past the optical fibres, the movable portion comprising a rotatably mounted substrate carrier for rotating the substrate relative to the radiation emitting and radiation receiving locations, whereby radiation emitted by the optical fibre at the emitting location passes through a transparent substrate in use and is received by the optical fibre at the receiving location.

Preferably, the apparatus further comprises a second monitoring apparatus having a radiation generator and radiation detector and for causing radiation to impinge on a substrate on the support and to detect radiation after impingement on the substrate, the processing system monitoring radiation received by the radiation receiver of the second monitoring apparatus.

This new invention allows the optical fibres coupled to the or each radiation generator and radiation detector to be located physically close together thus minimising misalignment drift and addressing the first problem mentioned above. In addition, because the optical fibres are mounted on the substrate support, the relative positions of those components and the substrate remains constant and is independent of movement of the support thus overcoming the second disadvantage of the conventional layout.

Typically, the wavelength of radiation (infrared, white light etc) will be selected to match the filter that is being deposited but, of course, the invention is equally applicable for use at any wavelength or any broad spectrum of wavelengths.

The use of optical fibres allows the generator and detector to be positioned remotely from the substrate support, typically outside the processing chamber where the environmental conditions will be more benign further away from the chamber. The detector, in particular, has a limited temperature specification. The easiest way to manage this is to move it to a cooler place.

The invention is applicable to various thin film deposition apparatus including ion beam sputter, magnetron sputter, also referred to as chemical vapour deposition (CVD), and plasma enhanced CVD (PECVD).

The term "thin film" is well known in the art and refers to films comprising layers deposited on a substrate by vacuum deposition. They can be from a single atomic layer to over a hundred microns thick but for this application they are typically a few hundred nanometers.

A further important aspect of the invention is that we have found that the structure for supporting the radiation emitter and radiation receiver can introduce noise which affects the precision of the monitoring process. To overcome this problem, we provide in the preferred example a system to compensate for temperature changes of the supporting structure, typically a bracket, and this compensation system preferably comprises a cooling system. The reason that noise is introduced is due to expansion and contraction of the supporting structure (bracket) and by providing temperature compensation, this problem can be significantly reduced.

An example of an ion beam sputter deposition apparatus according to the invention will now be described with reference to the accompanying drawings, in which:-
Figure 1 is a schematic, partly broken away perspective view of the apparatus;
Figure 2 is a schematic, perspective view of the substrate support and optical monitor mounting of Figure 1 shown in more detail and with some parts omitted for clarity; and,
Figure 3 is a block diagram of part of the apparatus.

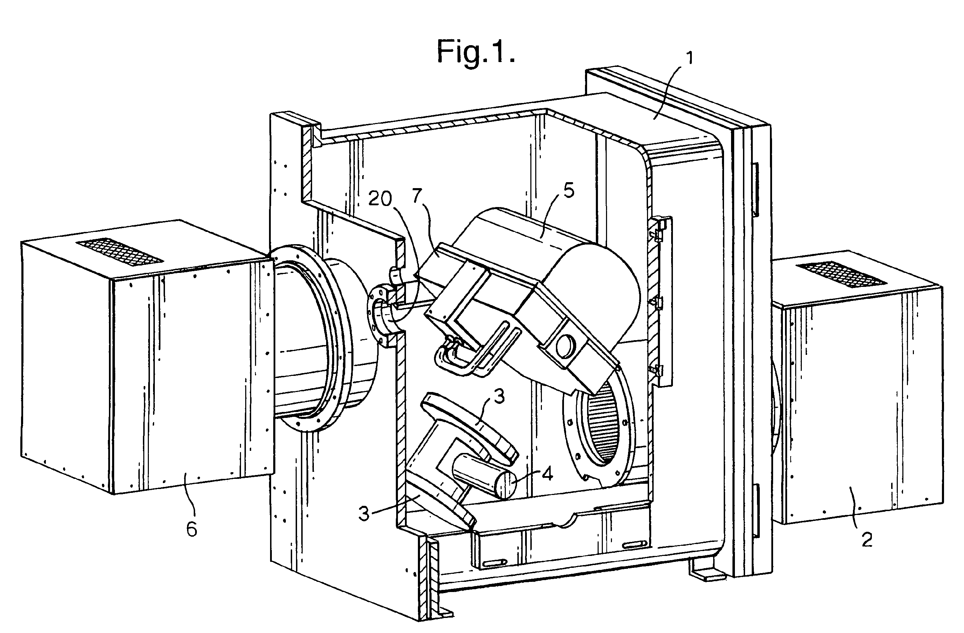

The apparatus shown in Figure 1 comprises a vacuum chamber 1. An ion source 2 ionises argon gas and accelerates the positive ions towards one of a pair of targets 3. Each target 3 is a disc of material, approximately 200mm in diameter and 6mm thick, attached to a water cooled target holder 4. The target holder 4 can rotate about its axis so that either of the targets 3 can be exposed to the ion beam, thus allowing the deposition of the two required materials. The incident ion beam erodes the surface of the target 3. This process is termed "Sputtering". A plume or flux of material is generated and travels perpendicularly from the surface of the target 3 towards a substrate holder 5. This holds the substrate (not shown), typically a 200 x 6mm disc of material that is optically transparent at the frequencies of interest, on to which the deposition flux is deposited to form the filter.

The substrates are made from a specialised type of glass with very low thermal drift and high quality surface finish. Typically, they have a very high internal transmittance at the wavelength of interest, e.g. > 98.5%, a defined refractive index with a very low temperature dependence. An example of the type of substrate is WMS02 manufactured by Ohara Corporation - a glass that is transparent over the waveband 370nm to 2µm. The substrate holder 5 can also be tilted about its own axis as shown. The ability to alter the position of the substrate and target holders 5,4 affords the user great flexibility in optimising the performance of the machine. The position of both the target and substrate holder are adjusted by servo mechanisms not shown on the diagram. The substrate holder 5 has a removable shield 7 that protects the substrate mechanism from being coated by the deposition flux not interrupted by the substrate. In order to give a good uniformity of deposition, the flux plume is made larger than the substrate and the "over-spray" coats the substrate holder. The shield 7 is removable so that it can be cleaned. In this example, no separate monitoring substrate is necessary.

A second ion source 6 is shown in Figure 1. This is used to ionise oxygen to help the deposition process. It is not relevant to this invention and has only been included for completeness.

The substrate is loaded onto the substrate holder 5 via a robotic arm which enters the chamber 1 via a normally sealed entry port 20. The substrate holder 5 is rotated until the substrate aligns with the centre axis of the entry port. It is sealed with a vacuum valve. Both the valve and the robotic arm have been omitted for clarity.

The vacuum is created in the chamber 1 by pumps attached to the bottom of the chamber. They are also not shown on the diagram.

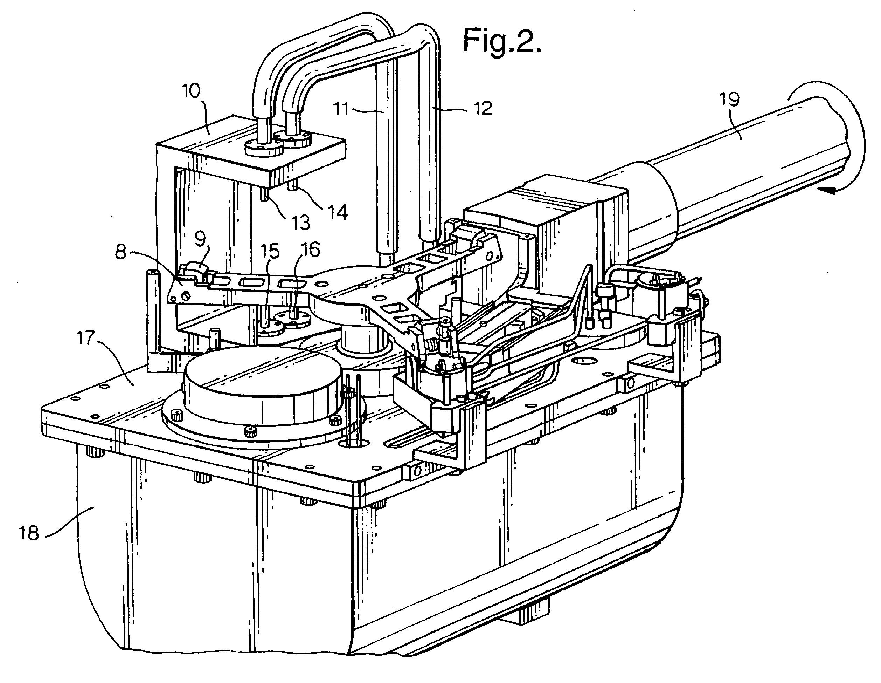

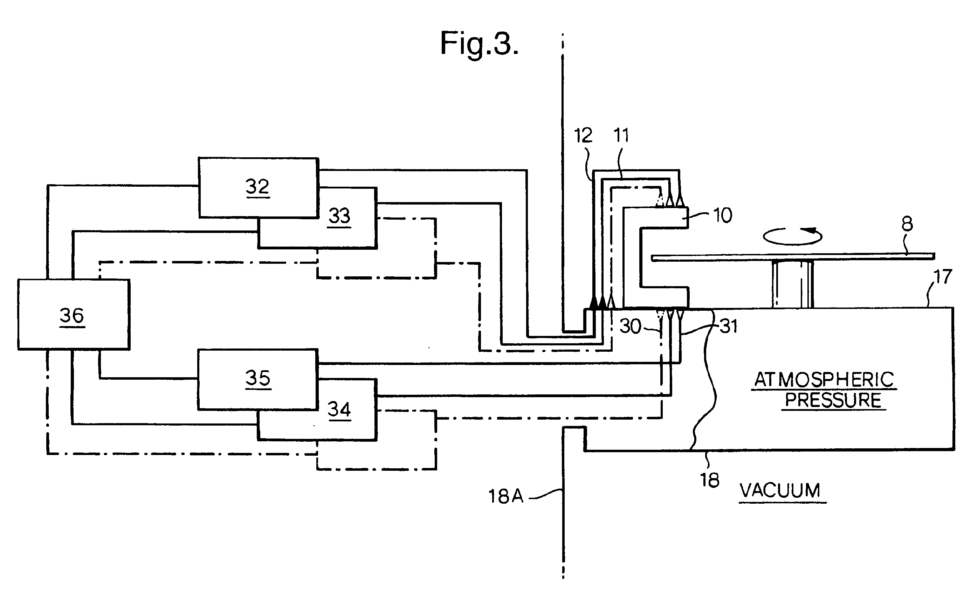

Figures 2 and 3 provide a more detailed view of the substrate holder 5 with the protective shield 7 removed. A three-pronged-platter 8 holds the substrate (not shown) with spring-loaded clamps 9. It spins about its own axis during deposition to improve the axial deposition uniformity. In similar designs the platter 8 and the clamping arrangement 9 are referred to collectively as the "Substrate chuck".

An optical sensor bracket 10 is mounted in the substrate holder 5 and accurately locates vacuum sealed fibre-optic cables within pipes or bellows 11,12. This protects the optical fibres from the harsh environment in the chamber 1 and avoids the need for vacuum compatible parts.

Similar vacuum sealed fibre-optic cables 30,31 are mounted below the spinning platter 8 such that light can be transmitted from respective sources 32,33 located outside the chamber 1 (for example optical and infrared sources respectively) perpendicularly through the substrate from each fibre in pipes 11, 12and received by the corresponding fibre 30,31 below the substrate. Each fibre 30,31 passes received light to a respective detector 34,35 located outside the chamber, each having a limited frequency response. The fibre-optic cables in pipes or bellows 11, 12 are terminated against vacuum sealed windows and protected by tube shields 13, 14. For infra-red light from the laser source 33, the vacuum sealed window has an anti-reflection coating to prevent multiple reflections from the two faces interfering with each other. The white light (optical) window has no such coating.

In the infra-red case, a fibre-optic collimator launches the light and collection is achieved by a fibre port. For the white light path, pairs of lenses (not shown) are used to do the same job. Basically, a lens pair focuses the light into the fibre optic cables and a similar arrangement collects it at the receiver.

Thus, a thin parallel beam is emitted from each cable and these pass through the spinning substrate. The beams are received by similar optical fibre cables 30,31 protected by shield protectors 15,16 and are fed to the detectors 34,35, such as a CCDs, for measurement. The receiving cables are perpendicular to the face of the spinning substrate enabling readings to be taken every revolution irrespective of the angle of the substrate.

As shown in Figure 3, more than two cables and associated light sources could be used. A preferred example has two emitters and two collectors to allow two wavelengths (e.g. 600nm and 1550nm) to be monitored simultaneously at substantially the same radius on the substrate. The optical components used in each path are selected to suit the different wavebands.

Alternatively, a single light source could supply light to each cable.

The light sources 32,33 and detectors 34,35 are connected to a control computer 36 and are all located outside the vacuum chamber 1. Thus the optical fibres within the pipes or bellows 11,12 are exposed to atmospheric pressure.

The optical sensor bracket 10 and the platter 8 are mounted on a plate 17. This plate 17 together with container 18 forms a vacuum sealed enclosure with the inside at atmospheric pressure, the chamber wall being shown at 18A. It houses the motor for platter rotation, the clamping actuators and associated sensors.

The entire assembly can be rotated through the centre axis of a supporting arm 19 to allow the angle between the substrate and the deposition flux to be varied. The relative position of the optical bracket 10 and substrate remains the same and is independent of the rotation thus ensuring that accurate monitoring is achieved. The platter 8, however, can rotate relative to the bracket 10.

The services, air, water, electrical power, control signals and the fibre optic cables enter the enclosure 1 via the hollow supporting arm 19. By sharing the same axis of rotation as the substrate holder 5 their range of movement is minimised reducing the stress on the cables and aiding the installation into the overall machine.

In order to achieve accurate alignment between the shields 13, 14 and protectors 15, 16, adjustable components (fibre ports or lenses) can be fitted at one end of each pair. A fibre port is a device that provides screw adjustment to position the end of the fibre such that light can be either received or transmitted over a wider range of angles.

During use the fibre optic cables within the bellows 11,12 can overheat due to their close proximity to the assist plasma source. The plastic buffer, the fibre's outer case, can melt leading to an increase in noise and its eventual failure. This can be overcome by adding air-cooling to the bellows, 11 and 12. It has been found that the water-cooling of the bracket 10, is sufficient to keep the fibre-port cool during processing. Water cooling is achieved via the bottom face of the bracket 10. This face forms a vacuum seal with the plate 17. Inlet and outlet water pipes (not shown) are connected via the arm 19 and cooled liquid is pumped through machined channels in the brackets. Cooling is important because if the bracket 10 heats up it will expand and cause the optics to shift relative to each other causing a signal change. The source of the cooling water is also critical in so much as its temperature must be extremely stable. In practice, it has been found necessary to install a separate closed-loop chilled water system specifically for this assembly. The system, or chiller as it is referred to, was selected for its precise and stable temperature control. It was found that the perturbations in temperature of the normal "house" cooling water were sufficient to cause changes in the output signal.

Another problem can be the initial coarse alignment of the beam. Infrared is not visible to the naked eye and unless the beam was close to the receiving optics the receiver would not register the presence of a signal. Consequently, it is impossible to know in which direction to make an adjustment. The solution is both simple and elegant; a small tube with a closed end made from beam finder card, this is card coated with phosphorous or similar and glows in the presence of infrared, is placed over the receiving shield protectors, items 15 and 16, and indicates the beam's position.

## Claims

1. Thin film deposition apparatus comprising a processing chamber (1) within which is mounted a movable substrate support (5); and monitoring apparatus having a radiation generator (32) and radiation detector (34) and for causing radiation to impinge on a substrate on the support and to detect radiation after impingement on the substrate, and a processing system (36) for monitoring radiation received by the radiation detector (34), **characterized in that** each of the radiation detector (34) and radiation generator (32) is coupled with respective optical fibres terminating at corresponding radiation receiving and emitting locations mounted on the substrate support (5) and located in use on opposite sides of a substrate on the support; and **in that** the substrate support (5) includes a portion (8) which is moveable relative to the radiation emitting and receiving locations so that a substrate can be moved past the optical fibres, the movable portion comprising a rotatably mounted substrate carrier (8) for rotating the substrate relative to the radiation emitting and radiation receiving locations, whereby radiation emitted by the optical fibre at the emitting location passes through a transparent substrate in use and is received by the optical fibre at the receiving location.

2. Apparatus according to claim 1, further comprising a second monitoring apparatus having a radiation generator (33) and radiation detector (35) and for causing radiation to impinge on a substrate on the support and to detect radiation after impingement on the substrate, the processing system monitoring radiation received by the radiation receiver of the second monitoring apparatus.

3. Apparatus according to claim 1 or claim 2, wherein the radiation is in the optical wave band or infrared waveband.

4. Apparatus according to claim 2 and claim 3, wherein the first monitoring apparatus uses optical radiation and the second monitoring apparatus uses infrared radiation.

5. Apparatus according to any of the preceding claims, wherein the or each radiation generator (32,33) and radiation detector (34,35) are located outside the processing chamber (1).

6. Apparatus according to any of the preceding claims, wherein the optical fibres are contained in tubes (11,12) held at atmospheric pressure.

7. Apparatus according to any of the preceding claims, further comprising a bracket (10) mounted about the substrate support (5) and extending partially over the substrate in use, the optical fibres being secured to the bracket.

8. Apparatus according to claim 7, further comprising a cooling system for cooling the bracket.

9. Apparatus according to claim 8, wherein the cooling system is a closed loop system.

10. Apparatus according to any of the preceding claims, further comprising a target support (3) located in the processing chamber and an ion beam source (2) for generating an ion beam which impinges on a target located on the target support in use.

11. Apparatus according to any of the preceding claims, wherein the apparatus is one of ion beam sputter, magnetron sputter and plasma enhanced CVD deposition apparatus.

## Patentansprüche

1. Dünnfilm-Abscheidungsvorrichtung umfassend eine Verarbeitungskammer (1), innerhalb der ein beweglicher Substrathalter (5) montiert ist; sowie eine Meßvorrichtung mit einem Strahlungsgenerator (32) und einem Strahlungsdetektor (34), die bewirkt, daß Strahlung auf ein Substrat auf dem Halter auftrifft und Strahlung nach dem Auftreffen auf das Substrat detektiert wird, sowie ein Verarbeitungssystem (36) zum Messen von vom Strahlungsdetektor (34) empfangener Strahlung, **dadurch gekennzeichnet, daß** sowohl der Strahlungsdetektor (34) als auch der Strahlungsgenerator (32) mit jeweiligen Lichtleitern gekoppelt sind, die an jeweiligen am Substrathalter (5) montierten Strahlungsempfangs- und Strahlungssendeorten montiert sind, und die in Betrieb an gegenüberliegenden Seiten eines Substrats auf dem Halter angeordnet sind; sowie **dadurch**, daß der Substrathalter (5) einen Abschnitt (8) aufweist, der bezüglich der Strahlungssende- und Strahlungsempfangsorte beweglich ist, so daß ein Substrat an den Lichtleitern vorbei bewegt werden kann, wobei der bewegliche Abschnitt einen rotierbar montierten Substratträger zum Rotieren des Substrats bezüglich der Strahlungssende- und Strahlungsempfangsorte umfaßt, wodurch Strahlung, die durch den Lichtleiter am Sendeort ausgesendet wird, in Betrieb durch ein transparentes Substrat gelangt und vom Lichtleiter am Empfangsort empfangen wird.

2. Vorrichtung nach Anspruch 1, die ferner eine zweite Meßvorrichtung mit einem Strahlungsgenerator (33) und einem Strahlungsdetektor (35) umfaßt, die bewirkt, daß Strahlung auf ein Substrat am Halter auftrifft und daß Strahlung nach dem Auftreffen auf dem Substrat detektiert wird, wobei das Verarbeitungssystem die vom Strahlungsempfänger der zweiten Meßvorrichtung empfangene Strahlung überwacht.

3. Vorrichtung nach Anspruch 1 oder 2, bei der sich die Strahlung im optischen Frequenzband oder infraroten Frequenzband befindet.

4. Vorrichtung nach Anspruch 2 oder 3, bei der die erste Meßvorrichtung optische Strahlung verwendet und die zweite Meßvorrichtung Infrarotstrahlung verwendet.

5. Vorrichtung nach einem der vorstehenden Ansprüche, bei der der oder jeder Strahlungsgenerator (32, 33) und Strahlungsdetektor (34, 35) außerhalb der Verarbeitungskammer (1) angeordnet sind.

6. Vorrichtung nach einem der vorstehenden Ansprüche, bei der die Glasfasern in Röhren (11, 12) enthalten sind, die auf Atmosphärendruck gehalten werden.

7. Vorrichtung nach einem der vorstehenden Ansprüche, die ferner eine Klammer (10) umfaßt, die um den Substrathalter (5) montiert ist und sich in Betrieb teilweise über das Substrat erstreckt, wobei die Glasfasern an der Klammer befestigt sind.

8. Vorrichtung nach Anspruch 7, die ferner ein Kühlsystem zum Kühlen der Klammer aufweist.

9. Vorrichtung nach Anspruch 8, bei der das Kühlsystem ein System mit einem geschlossenen Kreislauf ist.

10. Vorrichtung nach einem der vorstehenden Ansprüche, die ferner einen Target-Halter (3) aufweist, der in der Verarbeitungskammer angeodnet ist, sowie eine Ionenstrahlquelle (2) zur Erzeugung eines Ionenstrahls, der auf ein Target auftrifft, das in Betrieb auf dem Target-Halter angeordnet ist.

11. Vorrichtung nach einem der vorstehenden Ansprüche, bei dem die Vorrichtung ein Ionenstrahl-Sputter-, Magnetron-Sputter- oder eine PECVD-Abscheidungsvorrichtung ist.

## Revendications

1. Dispositif de dépôt de couches minces comprenant une chambre de traitement (1) à l'intérieur de laquelle est placé un support de substrat mobile (5) ; et un dispositif de mesure comprenant un générateur de rayonnement (32) et un détecteur de rayonnement (34) et ayant pour fonction d'amener un rayonnement à venir frapper un substrat sur le support et de détecter un rayonnement après incidence sur le substrat, ainsi qu'un système de traitement (36) destiné à surveiller un rayonnement reçu par le détecteur de rayonnement (34), **caractérisé en ce que** chacun du détecteur de rayonnement (34) et du générateur de rayonnement (32) est couplé à des fibres optiques respectives qui se terminent à des positions de réception et d'émission de rayonnement correspondants qui sont prévues sur le support de substrat (5) et actuellement employées sur des côtés opposés d'un substrat sur le support ; et **en ce que** le support de substrat (5) comprend une partie (8) qui est susceptible de se déplacer par rapport aux positions d'émission et de réception de rayonnement de telle sorte qu'un substrat peut être déplacé au delà des fibres optiques, la partie mobile comprenant un support de substrat monté de façon rotative (8) adapté pour faire tourner le substrat par rapport aux positions d'émission et de réception de rayonnement, moyennant quoi un rayonnement émis par la fibre optique au niveau de la position d'émission passe à travers un substrat transparent actuellement employé et est reçu par la fibre optique au niveau de la position de réception.

2. Dispositif selon la revendication 1, comprenant en outre un second dispositif de mesure comprenant un générateur de rayonnement (33) et un détecteur de rayonnement (35) et ayant pour fonction d'amener un rayonnement à venir frapper un substrat sur le support et de détecter un rayonnement après incidence sur le substrat, le système de traitement surveillant un rayonnement reçu par le récepteur de rayonnement du second dispositif de mesure.

3. Dispositif selon la revendication 1 ou 2, dans lequel le rayonnement se situe dans la gamme d'ondes optiques ou dans la gamme d'ondes infrarouges.

4. Dispositif selon les revendications 2 et 3, dans lequel le premier dispositif de mesure utilise un rayonnement optique et le second dispositif de mesure utilise un rayonnement infrarouge.

5. Dispositif selon l'une quelconque des revendications précédentes, dans lequel le - ou chacun des - générateur(s) de rayonnement (32, 33) et détecteur(s) de rayonnement (34, 35) est placé à l'extérieur de la chambre de traitement (1).

6. Dispositif selon l'une quelconque des revendications précédentes, dans lequel les fibres optiques sont contenues dans des tubes (11, 12) maintenus à la pression atmosphérique.

7. Dispositif selon l'une quelconque des revendications précédentes, comprenant en outre une plaque de fixation (10) qui est montée autour du support de substrat (5) et s'étend partiellement par dessus le substrat actuellement employé, les fibres optiques étant assurées à la plaque de fixation.

8. Dispositif selon la revendication 7, comprenant en outre un système de refroidissement pour refroidir la plaque de fixation.

9. Dispositif selon la revendication 8, dans lequel le système de refroidissement est un système en boucle fermée.

10. Dispositif selon l'une quelconque des revendications précédentes, comprenant en outre un support cible (3) disposé à l'intérieur de la chambre de traitement et une source de faisceau d'ions (2) destinée à générer un faisceau d'ions qui vient frapper un emplacement cible sur le support cible actuellement employé.

11. Dispositif selon l'une quelconque des revendications précédentes, dans lequel le dispositif est l'un d'entre un dispositif de pulvérisation de faisceau d'ions, un magnétron, un dispositif de dépôt CVD amélioré à pulvérisation et plasma.
